Europäisches Patentamt

European Patent Office

Office européen des brevets

(19)

(11) Veröffentlichungsnummer: **0 320 517 B1**

(12) **EUROPÄISCHE PATENTSCHRIFT**

(45) Veröffentlichungstag der Patentschrift: **12.08.92**

(51) Int. Cl.5: **H03H 17/06**

(21) Anmeldenummer: **87118434.7**

(22) Anmeldetag: **12.12.87**

(54) **Digitales Dezimationsfilter.**

(43) Veröffentlichungstag der Anmeldung:
**21.06.89 Patentblatt 89/25**

(45) Bekanntmachung des Hinweises auf die
Patenterteilung:
**12.08.92 Patentblatt 92/33**

(84) Benannte Vertragsstaaten:
**DE FR GB IT NL**

(56) Entgegenhaltungen:

**IEEE TRANSACTIONS ON ACOUSTICS, SPE-
ECH AND SIGNAL PROCESSING, Band ASSP-
29, Nr. 2, April 1981, Seiten 155-162, IEEE,
New York, US; E.B. HOGENAUER: "An economical class of digital filters for decimation
and interpolation"**

**IEEE TRANSACTIONS ON CIRCUITS AND SY-
STEMS, Band CAS-31, Nr. 11, November
1984, Seiten 913-924, IEEE, New York, US; S.
CHU et al.: "Multirate filter designs using
comb filters"**

(73) Patentinhaber: **Deutsche ITT Industries GmbH
Hans-Bunte-Strasse 19 Postfach 840
W-7800 Freiburg i.Br.(DE)**

(72) Erfinder: **Pfeifer, Heinrich, Dipl.-Ing.
Hinterhofstrasse 50
W-7819 Denzlingen(DE)**
Erfinder: **Reich, Werner, Dr.-Ing.
Kleisstrasse 2a
W-7830 Emmendingen(DE)**
Erfinder: **Winterer, Martin, Dipl.-Phys..
Hofackerstrasse 91a
W-7800 Freiburg i.Br.(DE)**

**Beschreibung**

In digitalen Systemen tritt häufig der Fall auf, daß von einer vorgegebenen Eingangsabtastfrequenz, mit der zu verarbeitende digitale Daten auftreten, auf eine niedrigere Ausgangsabtastfrequenz überzugehen ist. Dies wird in der Fachliteratur als Dezimation bezeichnet. Diese besteht aus den beiden Teilmaßnahmen Filterung und nachfolgendes down sampling. Dabei läßt die Tatsache, daß wegen des down samplings nicht jedes der Ausgangsdaten des Dezimationsfilters benötigt wird, eine Vereinfachung der Filterstruktur zu. In vielen digitalen Systemen, insbesondere im Zusammenhang mit sogenannten überabgetasteten Analog-Digital-Wandlern - bei diesen liegt die Abtastfrequenz höher, als sie nach dem Abtasttheorem liegen müßte -, wird eine Kaskade von mehreren gleitenden Mittelwertbildnern (im Englischen moving time averager) als Dezimationsfilter eingesetzt. Seine Übertragungsfunktion lautet:

$$H(z) = b(1 + z^{-1} + ... + z^{-n+1})^m$$
$$= b(1-z^{-n})^m/(1-z^{-1})^m,$$

wobei n der ganzzahlige Quotient aus der Eingangsabtastfrequenz r der Eingangsdaten und der Ausgangsabtastfrequenz d der Ausgangsdaten sowie z die komplexe Frequenzvariable ist.

Ein durch den ganzzahligen Parameter k größer oder gleich eins verallgemeinertes Dezimationsfilter erlaubt die Variation der Bandbreite in Abhängigkeit von k; die Übertragungsfunktion lautet dann:

$$H(z) = b(1 + z^{-1} + ... + z^{-kn+1}) (1 + z^{-1} + ... + z^{-n+1})^{m-1}$$
$$= b(1-z^{-kn})(1-z^{-n})^{m-1}/ (1-z^{-1})^m.$$

Diese Übertragungsfunktion besitzt mindestens einfache Nullstellen (entspricht unendlicher Dämpfung) bei Frequenzen, die ein ganzzahliges Vielfaches von d/k sind und m-fache Nullstellen bei Vielfachen von d.

In "IEEE Transactions on Circuits and Systems", Bd.CAS-31, Nr. 11, Nov. 1984, Seiten 913 bis 924 wird unter dem Titel "Multirate Filters Designs Using Comb Filters" die grundsätzliche Funktion von digitalen Dezimations- und Interpolationsfiltern beschrieben, die als Filtergrundglieder in Kaskadenschaltung mindestens einen Integrierer, Differenzierer und Abtaster aufweisen. Bei den Dezimationsfiltern wird durch den Abtaster die Ausgangsabtastfrequenz gegenüber der Eingangsabtastfrequenz um einen festen Faktor reduziert. Die Reihenfolge von Integrierung ( = Summation) und Differenzierung ( = Subtraktion) bewirkt, daß am Ausgang des Dezimationsfilters immer der Mittelwert von denjenigen Eingangsdaten gebildet wird, die innerhalb des begrenzten Zeitintervalles liegen, das vom Ausgangsdatentakt bestimmt wird. Dabei wird gleichsam von dem Summenwert einer unendlich langen Folge jeweils der um das Zeitintervall zurückliegende Summenwert wieder abgezogen, wodurch als Rest die Summe des letzten Zeitintervalls übrigbleibt, die den gewünschten Mittelwert mit einem Skalierungsfaktor liefert. Die ständige Aufsummierung von Daten im Eingang der Dezimationsfilter führt zu einem "Überlaufen" der Integrierer. Dies entspricht jedoch der Modulo-Arithmetik der zu verarbeitenden Zweierkomplementzahlen und führt daher zu keinem Fehler beim Endergebnis.

Die Ausbildung der digitalen Integrierer und der digitalen Differenzierer mit Hilfe von Verzögerern und Addierern bei Integrierern bzw. Verzögerern und Subtrahierern bei Differenzierer ist beispielsweise in "IEEE Transactions On Acoustics, Speech, and Signal Processing", Bd. ASSP-29, No. 2, April 1981, Seiten 155 bis 162 unter dem Titel: "An Economical Class of Digital Filters for Decimation and Interpolation" beschrieben. Beim Integrierer liegt im Signalflußzweig ein Addierer, dessen zweiter Eingang von einem in einem Rückkopplungszweig liegenden Verzögerer gespeist ist, dessen Verzögerungszeit eine Taktperiode des Eingangsdatentaktes beträgt und dessen Eingang am Ausgang des Addierers liegt. Beim Differenzierer speist das Eingangssignal gleichzeitig den Minuendeingang eines Subtrahierers und den Eingang eines um eine Taktperiode des Ausgangsdatentaktes verzögernden Verzögerers. Der Ausgang dieses Verzögerers ist mit dem Subtrahendeingang des Subtrahierers verbunden, dessen Ausgang das differenzierte Signal liefert.

Wenn bei der Realisierung eines Dezimalfilters mit der letztgenannten Übertragungsfunktion die Zweierkomplementdarstellung von Dualzahlen angewendet wird, ergibt sich aus der Interpretation, daß sie lediglich Zahlen im Bereich zwischen -1 und +1 seien, keine Einschränkung der Allgemeingültigkeit. Das Ausgangssignal des Dezimationsfilters ist mit Sicherheit nicht übersteuert, wenn die Bedingung b kleiner/gleich $1/kn^m$ erfüllt ist.

Da die Übertragungsfunktion H(z) als Produkt mehrerer Faktoren geschrieben werden kann, ergeben sich je nach Reihenfolge der Faktoren eine Vielfalt von verschiedenen Dezimationsfilterschaltungen zur Realisierung der Übertragungsfunktion. Von besonderem Interesse sind solche Realisierungen, die einen möglichst geringen Schaltungsaufwand erfordern, also bei der Herstellung als monolithisch integrierte Schaltung mit möglichst wenig Kristallfläche auskommen.

Die Aufgabe der in den Ansprüchen gekennzeichneten Erfindung besteht somit darin, für die oben letztgenannte Übertragungsfunktion eine Schaltungsanordnung anzugeben, die unter den genannten Gesichtspunkten besonders günstig ist.

Die Erfindung wird nun anhand der Figuren der Zeichnung näher erläutert.

Fig. 1 zeigt in Form eines stark schematisierten Blockschaltbildes die Schaltungsstruktur der erfindungsgemäßen Dezimationsfilterschaltung, und

Fig. 2 zeigt wiederum als stark schematisiertes Blockschaltbild eine Abwandlung bzw. Weiterbildung der Anordnung nach Fig. 1.

Bei der Erfindung wird die oben genannte Nichtübersteuerungsbedingung für b dadurch realisiert, daß diejenige Zweierpotenz $2^{-q}$ für b gewählt wird, die entweder gleich dem Quotienten $1/kn^m$ ist - wenn dieser eine Zweierpotenz ist - oder die die diesem Quotienten nächstliegende kleinere Zweierpotenz ist.

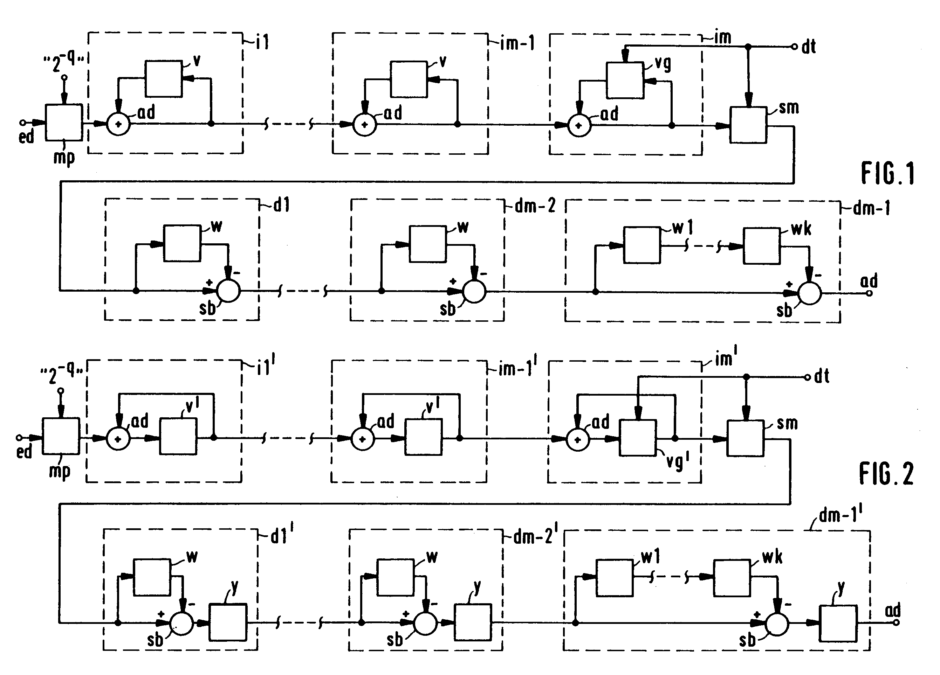

In Fig. 1 liegt demzufolge am Anfang der Digitalfilterschaltung der Multiplizierer mp, dessen einem Eingang die zu dezimierenden Eingangsdaten ed und dessen anderem Eingang ein die Zweierpotenz $2^{-q}$ repräsentierendes Digitalwort "$2^{-q}$" zugeführt sind. Dem Ausgang des Multiplizierers mp folgen m-1 Integrierer, von denen in der Figur der Integrierer i1, im-1 gezeigt sind. Jeder dieser Integrierer besteht aus dem zwischen seinem Eingang und seinem Ausgang liegenden Addierer ad und dem zwischen dem Integriererausgang und dem Addierer liegenden Verzögerer v, der um die Periodendauer der Eingangsabtastfrequenz r der Eingangsdaten ed verzögert. Der Addierer ad hat somit zwei Eingänge, an deren einem der Ausgang des Multiplizierers mp (beim Integrierer i1) bzw. der Ausgang des vorangehenden Integrierers (bei den nachfolgenden Integrierern) und an deren anderem der Ausgang des jeweiligen Verzögerers v liegt.

Auf den vorletzten Integrierer im-1 folgt der letzte Integrierer im, dessen Innenschaltung von prinzipiell gleicher Art ist wie die der übrigen Integrierer, bei dem jedoch der Verzögerer vg durch den Ausgangsabtasttakt dt zurückgestellt wird. Somit wird das aufsummierte Ergebnis während jeder Periodendauer des Ausgangsabtasttakts dt einmal zurückgestellt, was vorzugsweise zu Beginn jeder Periodendauer geschieht.

Dem Ausgang des Integrierers im ist der Abtaster sm nachgeschaltet, der vom Dezimationstakt dt gesteuert ist und der somit die Dezimation der Datenrate bewirkt. Ihm folgt die Kette der m-1 Differenzierer d1, dm-2, dm-1, von denen die ersten m-2 gleichartig aufgebaut sind. Zwischen deren jeweiligem Eingang und Ausgang liegt die Minuendeingang-Ausgangs-Strecke des Subtrahierers sb, dessen Subtrahend-Eingang am Ausgang des um die Periodendauer des Ausgangsabtasttakts dt verzögernden Verzögerers w liegt, dessen Eingang am Eingang des Differenzierers liegt.

Der letzte Differenzierer dm-1, an dessen Ausgang die dezimierten Ausgangsdaten da auftreten, enthält anstatt des einzigen Verzögerers w bei den m-2 ersten Differenzierern d1, dm-2 die Hintereinanderschaltung von k um die Periodendauer des Ausgangsdatentakts dt verzögernden Verzögerern w1, wk.

Aus der oben erwähnten Multiplikation mit der Zweierpotent $2^{-q}$ ergibt sich, daß die in der Digitalfilterschaltung zu verarbeitenden Signale die Stellenzahl p + q aufweisen, wobei mit p die Stellenzahl der Eingangsdaten ed bezeichnet ist.

Die Erfindung scheint bei oberflächlicher Betrachtung nicht sinnvoll zu sein, da am Eingang der Dezimationsfilterschaltung eine Kaskade von digitalen Integrierern vorgesehen ist, bei denen z.B. ein beliebig kleines Gleichsignal am Eingang zu einem Überlauf der Integrierer führt. Dies muß bei der Erfindung jedoch zugelassen werden und führt überraschenderweise zu keiner Fehlfunktion, da das Überlaufen der Integrierer durch das Überlaufen der Subtrahierer in den Differenzierern wieder völlig ausgeglichen wird. Das Überlaufen darf also nicht unterdrückt werden.

In Fig. 2 ist eine Abwandlung bzw. Weiterbildung der Anordnung nach Fig. 1 gezeigt, mit der allfällig dabei auftretende Zeit- bzw. Geschwindigkeitsprobleme gelöst werden können, die sich daraus ergeben, daß das Ausgangssignal der Addierer und Subtrahierer noch in derselben Periodendauer der Eingangs- bzw. der Ausgangsabtastfrequenz in folgenden Addierern bzw. Subtrahierern benötigt wird. Dieses Problem kann dadurch gelöst werden, daß an geeigneten Stellen zusätzliche Verzögerer vorgesehen werden.

Demnach ist bei der Anordnung nach Fig. 2 zunächst deutlich sichtbar in den Differenzierern d1', dm-2', dm-1' jeweils der weitere Verzögerer y vorgesehen, der wiederum um die Periodendauer des Ausgangsabtasttakts dt verzögert und zwischen dem Ausgang des Subtrahierers sb und dem Ausgang des jeweiligen Differenzierers angeordnet ist.

Der an sich bei den Integrierern i1, im-1 nach Fig. 1 vor deren Ausgang anzuordnende weitere Verzögerer kann mit dem vorhandenen Verzögerer v vereinigt werden, wenn die Reihenfolge von Addierer ad und Verzögerer v' so gewählt wird, wie dies in Fig. 2 gezeigt ist. Addierer ad und Verzögerer v' liegen nun signalflußmäßig in Reihe, so daß nicht wie bei den Integrierern nach Fig. 1 das Ausgangssignal des Addierers verzögert auf den Addierer zurückgeführt wird, sondern das Ausgangssignal des Verzögerers v' zum Addierer ad. Ebenso wird im letzten Integrierer im' der rücksetzbare Verzögerer vg' angeordnet, d.h. Addierer ad und Verzögerer vg' liegen signalflußmäßig in Reihe, und dessen Ausgangssignal ist zum Addierer ad zurückgeführt.

Somit ist bei der Anordnung nach Fig. 2 gewährleistet, daß jeder Addierer bzw. Subtrahierer eine ganze Periodendauer des Eingangs- bzw. des Ausgangsdatentakts Zeit hat, um das Ausgangssignal zu liefern.

## Patentansprüche

1. Digitalfilterschaltung zur Realisierung eines Dezimationsfilters
   - mit der Übertragungsfunktion

   $$H(z) = b(1-z^{-kn})(1-z^{-n})^{m-1}/(1-z^{-1})^{m},$$

   in der z die komplexe Frequenzvariable, k ein ganzzahliger Parameter zur Einstellung der Bandbreite der Digitalfilterschaltung, m eine Zahl, die angibt, wieviel Filtergrundglieder in Kaskade geschaltet sind, n der ganzzahlige Quotient aus der Eingangsabtastfrequenz (r) der Eingangsdaten (ed) und der Ausgangsabtastfrequenz (d) der Ausgangsdaten (ad) sowie b ein in einer Zweierpotenz $2^{-q}$ vorliegender Skalierungsfaktor ist und Glieder der Form $(1-z^{-\cdots})$ als Differenzierer sowie Glieder der Form $1/(1-z^{-\cdots})$ als Integrierer bezeichnet sind,
   - mit in Signalflußrichtung vorgenommener Hintereinanderschaltung folgender Glieder:
     - m Integrierer (i1, .., im) mit einem zwischen Eingang und Ausgang liegenden Addierer (ad) und einem zwischen Ausgang und Addierer liegenden, um die Periodendauer der Datenrate (r) verzögernden Verzögerer (v),
     - ein im Ausgangsdatentakt (dt) geschalteten Abtaster (sm),
     - m-2 Differenzierer (d1, ..., dm-2), die jeweils einen Subtrahierer (sb) und einen um die Periodendauer des Ausgangsdatentaktes (dt) verzögernden Verzögerer (w) enthalten und
     - einen (m-1)ten Differenzierer (dm-1) mit k um die Periodendauer des Ausgangsdatentaktes (dt) verzögernden Verzögerern (w1, ..., wk),
     gekennzeichnet durch folgende Merkmale:
     - der m-te Integrierer (im) ist ein durch den Ausgangsdatentakt (dt) zurückgestellter Integrierer, der durch die Zurückstellung zusätzlich als Differenzierer wirkt,
     - am Eingang der Digitalfilterschaltung liegt ein Multiplizierer (mp) mit dem Multiplikationsfaktor $2^{-q}$, wobei $2^{-q}$ kleiner/gleich $1/kn^{m}$ ist, und
   - die zu verarbeitende Stellenzahl in der Digitalfilterschaltung ist b + q, wobei b die Stellenzahl der Eingangsdaten (ed) bezeichnet.

2. Digitalfilterschaltung nach Anspruch 1, gekennzeichnet durch folgende Merkmale:
   - die dm-1 Differenzierer (d1', ..., dm-1') enthalten zwischen ihrem jeweiligen Ein- und Ausgang eine Reihenschaltung aus dem Subtrahierer (sb) und einem weiteren um die Periodendauer des Ausgangsdatentaktes (dt) verzögernden Verzögerer (y), wobei der Minuendeingang des Subtrahierers (sb) mit dem Eingang des Differenzierers und mit dem Eingang des Verzögerers (w) verbunden ist, dessen Ausgang an den Subtrahendeingang des Subtrahierers (sb) angeschlossen ist,
   - die m-1 Integrierer (i1', ..., im-1') enthalten zwischen ihrem jeweiligen Ein- und Ausgang eine Reihenschaltung aus dem Addierer (ad) und dem Verzögerer (v'), wobei der Ausgang des Verzögerers (v') zum Eingang des Addierers (ad) zurückgeführt ist, und
   - der m-te Integrierer (im') enthält zwischen seinem Ein- und Ausgang eine Reihenschaltung aus dem Addierer (ad) und dem zurückstellbaren Verzögerer (vg'), wobei der Ausgang des zurückstellbaren Verzögerers (vg') zum anderen Eingang des Addierers (ad) zurückgeführt ist.

## Claims

1. A digital filter circuit for implementing a decimation filter
   - having the transfer function

   $$H(z) = b(1-z^{-kn})(1-z^{-n})^{m-1}/(1-z^{-1})^{m},$$

   where z is the complex frequency variable, k is an integral parameter for adjusting the bandwidth of the digital filter circuit, m is a number which specifies how many basic filter sections are cascaded, n is the integral quotient of the input sampling frequency (r) of the input data (ed) and the output sampling frequency (d) of the output data (ad), and b is a scale factor in the form of a power of two $2^{-q}$, with terms of the form $(1-z^{-\cdots})$ referred to as differentiators, and terms of the form 1/(1-z⁻···) as integrators, and
- comprising a cascade arrangement of the following sections:
    - m integrators (i1, ..., im) each containing an adder (ad) between its input and output and a delay element (v) between its output and the adder, the delay element (v) introducing a delay equal to the period of the data rate (r),
    - a sampling device (sm) switched at the output data clock rate (dt),
    - m-2 differentiators (d1, ..., dm-2) each containing a subtracter (sb) and a delay element (w) which introduces a delay equal to the period of the output data clock (dt), and
    - an (m-1)st differentiator (dm-1) comprising k delay elements (w1, ..., wk) which each introduce a delay equal to the period of the output data clock (dt),
    characterized by the following features:
- The mth integrator (im) is an integrator which is reset by the output data clock (dt) and, through the resetting, additionally acts as a differentiator;
- located at the input of the digital filter circuit is a multiplier (mp) with the multiplication factor $2^{-q}$, where $2^{-q}$ is less than/equal to $1/kn^m$, and
- the number of bits to be processed in the digital filter circuit is b + q, where b is the number of bits in the input data (ed).

2. A digital filter circuit as claimed in claim 1, characterized by the following features:
    - The dm-1 differentiators (d1', ..., dm-1') contain between their respective inputs and outputs a series combination of the subtracter (sb) and an additional delay element (y) which introduces a delay equal to the period of the output data clock (dt), with the minuend input of the subtracter (sb) connected to the input of the differentiator and to the input of the delay element (w), whose output is coupled to the subtrahend input of the subtracter (sb);
    - the m-1 integrators (i1', ..., im-1') contain between their respective inputs and outputs a series combination of the adder (ad) and the delay element (v'), with the output of the delay element (v') fed back to the input of the adder (ad), and
    - the mth integrator (im') contains between its input and output a series combination of the adder (ad) and a resettable delay element (vg'), with the output of the resettable delay element (vg') fed back to the other input of the adder (ad).

## Revendications

1. Circuit de filtre numérique pour réaliser un filtre de décimation, comportant
    - la fonction de transfert

    $$H(z) = b(1-z^{-kn})(1-z^{-n})^{m-1}/(1-z^{-1})^m,$$

    dans laquelle z représente la variable de fréquence complexe, k un paramètre formé d'un nombre entier pour le réglage de la largeur de bande du circuit de filtre numérique, m un nombre indiquant combien de circuits de base du filtre sont branchés en cascade, n le quotient soins forme d'un nombre entier entre la fréquence d'échantillonnage (r) des données d'entrée (ed) et la fréquence d'échantillonnage de sortie (d) des données de sortie (ad) et b un facteur d'échelle présent sous la forme d'une puissance de deux $2^{-q}$, et des circuits correspondant à la forme (1-z⁻···) étant désignés comme étant des circuits différenciateurs, tandis que des circuits correspondant à la forme 1/(1-z⁻···) étant désignés comme sont des intégrateurs,
    - le montage en série, dans le sens de transmission des signaux, des circuits suivants :
        - m intégrateurs (i1,...,im) comportant un additionneur (ad) situé entre une entrée et une sortie, et un circuit de retardement (v) situé entre la sortie et l'additionneur et qui produit un retard égal à la durée de la période de la cadence de données (r),
        - un échantillonneur (sm) commuté à la cadence des données de sortie (dt),
        - m-2 circuits différenciateurs (d1,...,dm-2), qui contiennent chacun un soustracteur (sb) et un circuit de retardement (w) réalisant un retard sur la durée de la période de la cadence de données de sortie (da), et
        - un (m-1)-ème circuit différenciateur (dm-1) comportant k circuits de retardement (w1,...wk) réalisant un retard égal à la durée de la période de la cadence des données de sortie (dt),
        caractérisé par les caractéristiques suivantes :
        - le m-ème intégrateur (im) est un intégrateur, ramené à l'état initial par la cadence des données de sortie (dt) et qui agit en outre, sous l'effet de la remise à l'état initial, en tant que circuit différenciateur,

- à l'entrée du circuit de filtre numérique est branché un multiplicateur (mp) qui possède le facteur multiplicatif ($2^{-q}$), $2^{-q}$ étant égal/inférieur à $1/kn^m$, et
- le nombre de chiffres devant être traité dans le circuit de filtre numérique est égal à b + q, b désignant le nombre de chiffres des données d'entrée (ed).

2. Circuit de filtre numérique selon la revendication 1, caractérisé par des caractéristiques suivantes :

- les dm-1 circuits différenciateurs (d1',...,dm-1') contiennent entre leurs entrée et sortie respectives, un circuit série formé du soustracteur (sb) et un autre circuit de retardement (y) qui réalise un retard égal à la durée de la période de la cadence des données de sortie (dt), l'entrée du minuende du soustracteur (sb) étant raccordée à l'entrée du circuit différenciateur et à l'entrée du circuit de retardement (w), dont la sortie est raccordée à l'entrée du nombre à soustraire du soustracteur (sb),
- les m-1 intégrateurs (i1',...,im-1') contiennent, entre leurs entrée et sortie respectives, un circuit série formé de l'additionneur (ad) et du circuit de retardement (v'), la sortie du circuit de retardement (v') étant raccordée par réaction à l'entrée de l'additionneur (ad), et
- le m-ème intégrateur (im') contient, entre son entrée et sa sortie, un circuit série formé de l'additionneur (ad) et du circuit de retardement (vg') pouvant être amené à zéro, la sortie du circuit de retardement (vg') pouvant être ramenée à zéro étant raccordée par réaction à l'autre entrée de l'additionneur (ad).

FIG.1

FIG.2